# EUROPÄISCHE PATENTANMELDUNG

(11) **EP 0 940 479 A1**
(43) Veröffentlichungstag der Anmeldung: **08.09.1999**
(21) Anmeldenummer: 99102279.9
(22) Anmeldetag: 05.02.1999
(51) Int. Cl.: C23C 14/06, C23C 14/08, C23C 14/16, C23C 28/00

(54) **Messingfarbige Beschichtung mit einer farbgebenden nitridischen Schicht**

(30) Priorität: 05.03.1998 DE 19809408
(71) Anmelder: Leybold Systems GmbH, 63450 Hanau (DE)
(72) Erfinder: Budke, Elisabeth, Dr., 50354 Hürth (DE); Kremprel-Hesse, Jörg, Dr., 63683 Eckartsborn (DE); Maidhof, Hans, 63773 Goldbach (DE); Schüssler, Hans, 66578 Schiffweiler (DE)

(57) **Zusammenfassung**

Bei einer messingfarbigen Beschichtung mit einer farbgebenden nitridischen Schicht für Armaturen, Beschläge oder Artikel des täglichen Bedarfs ist die nitridische Schicht eine Zirkoniumnitridschicht, die unmittelbar auf das Substrat oder auf eine das Substrat überziehende Grundschicht, beispielsweise eine Zirkoniumschicht, unter Verwendung eines Argon-Stickstoff-Gemisches als Zwischenschicht aufgestäubt, wobei auf die Zwischenschicht zum Zwecke des Korrosionsschutzes als Deckschicht eine transparente oxidische Hartstoffschicht, vorzugsweise eine Zirkoniumoxidschicht, unter Verwendung eines Sauerstoff-Argon-Gemisches aufgestäubt ist.

## Beschreibung

Die Erfindung betrifft eine messingfarbige Beschichtung mit einer farbgebenden nitridischen Schicht für Badarmaturen, Beschläge und Artikel des täglichen Bedarfs. Die Erfindung betrifft ferner die mit dieser Beschichtung versehenen Artikel und das Verfahren zu ihrer Herstellung.

Bekannt ist eine goldfarbige, Zirkoniumnitrid enthaltende Beschichtung, wobei die- Schicht aus Zirkoniumnitrid und Tantalnitrid mit einem Tantalanteil von 3 Gew.% bis 68 Gew.% Zusammengesetzt ist (DE 37 28 836 C2).

Bekannt sind weiterhin Überzüge für metallische Gebrauchs- und Ziergegenstände (DE 25 28 255), die Karbide und/oder Nitride und/oder Karbonitride und/oder Boride der Elemente Titan, Zirkonium, Hafnium, Niob, Tantal, Wolfram, Lanthan, Cer und Gadolinium enthalten. Diese Stoffe können einzeln, in Form von Mischungen oder Mischkristallen verwendet werden. Zum Aufbringen der Überzüge sind die Abscheidung aus der Gasphase, die Sputtertechnik und des Plasmaspritzen angegeben. Überzüge allein aus Titannitrid, aus Titankarbid, aus 10 % Titankarbid und 90 % Titannitrid, aus LaB₆ sowie aus 15 % Titankarbid und 85 % Titannitrid sind als besondere Beispiele aufgeführt.

Weiterhin sind Artikel bekannt (US 5,552,233) mit einer sowohl dekorativ wirkenden als auch die Gegenstände schützenden mehrlagigen Beschichtung, wobei die Schichten selbst den Eindruck von Messing vermitteln. Das Schichtpaket besteht aus einer ersten Schicht aus halbglänzendem Nickel, einer zweiten Schicht aus hochglänzendem Nickel, einer dritten Schicht aus einer Zinn-Nickel-Legierung, einer vierten Schicht aus Zirkonium oder Titan oder Zirkoniumnitrid und einer Deckschicht aus einer Zirkonium- oder Titanverbindung.

Weiterhin ist bereits ein Schichtpaket für ein Interferenzfilter vorgeschlagen worden (EP 0 622 654), bei dem auf ein Substrat aus durchscheinendem Werkstoff eine erste Schicht aus teilweise lichtdurchlässigem, dielektrischem Werkstoff, eine zweite Schicht aus Nickel oder Chromnitrid, darauffolgend eine dritte, reflektierende Metallschicht aus Silber, Gold, Kupfer oder Platin, darauffolgend eine vierte Schicht aus Nickel oder Chrom und schließlich eine Deckschicht aus Zirkoniumnitrid, Titannitrid oder Hafniumnitrid aufgebracht ist.

Schließlich ist ein Verfahren zur Herstellung goldfarbener Überzüge auf Substraten durch Verdampfen von Metallen bei Unterdruck bekannt (DE 30 27 404), bei dem die Metalle Titan, Zirkonium oder Hafnium sind, die in einer Stickstoff enthaltenden Restgasatmosphäre unter gleichzeitiger Aktivierung des Restgases durch eine elektrische Gasentladung aufgebracht werden, wobei die Gasentladung eine Niedervoltbogenentladung zwischen einer Glühkathode und einer Anode ist und das Restgas eine kohlenstoffhaltige, gasförmige Verbindung enthält und die zu beschichtenden Substrate auf eine gegenüber dem Gehäuse negative Vorspannung gelegt sind.

Der vorliegenden Erfindung liegt die Aufgabe zugrunde, ein Schichtsystem zu schaffen, bei dem die Farbe der Schichten so einstellbar ist, daß sie messingfarbig erscheint, auch bei intensiver Nutzung farbstabil, kratzfest, abriebfest, hart und korrosionsfest bleibt und in einfachen Anlagen und ohne Unterbrechung herstellbar ist.

Diese Aufgabe wird erfindungsgemäß dadurch gelöst, daß die nitridische Schicht eine Zirkoniumnitridschicht ist und unmittelbar auf das Substrat oder auf eine das Substrat überziehende Grundschicht, beispielsweise eine Zirkoniumschicht als Zwischenschicht aufgebracht ist, wobei zum Zwecke des Korrosionsschutzes als Deckschicht eine transparente oxidische Hartstoffschicht, vorzugsweise eine Zirkoniumoxidschicht niedergeschlagen ist.

Vorzugsweise erfolgt das Aufbringen der Zwischenschicht durch Aufstäuben, wozu dem Substrat benachbart in der Prozeßkammer eine Magnetronquelle mit einem Zirkonium-Target angeordnet ist und als Prozeßgas ein Gemisch aus Argon und Stickstoff dient, wobei das Aufbringen der Deckschicht durch Aufstäuben unter Verwendung eines Zirkonium-Targets in einem Gemisch aus Argon und Sauerstoff als Prozeßgas erfolgt.

Mit Vorteil ist die Zwischenschicht eine Zirkoniumnitridschicht mit einer Dicke von 50 nm bis 800 nm und die Deckschicht eine Zirkoniumoxidschicht mit einer Dicke von 1 nm bis 50 nm.

Die Erfindung läßt die verschiedensten Ausführungsmöglichkeiten zu; eine davon ist nachstehend anhand einer Zeichnung näher beschrieben.

Die Anlage zum Beschichten von Substraten wie beispielsweise Badarmaturen oder Möbelbeschlägen besteht im wesentliche aus einer Vakuumkammer 3 mit einem Anschluß 4 für eine Turbopumpe (Vakuumpumpe), einer in den Anschluß 4 eingebauten Saugleistungsregelung 5, einem elektrisch isolierten Substrathalter 8 für die Substrate 7,7',..., einem HF-Generator 6 mit Anpaßnetzwerk 9, einer dem Substrathalter 8 gegenüberliegend angeordneten Magnetronquelle 10 mit Target 11, Kühleinrichtung 12 und Magnetjoch 13, einem Stutzen 14 für den Einlaß von Prozeßgas in die Vakuumkammer 3 und einem Generator 15 mit Anpaßnetzwerk 16 für die Stromversorgung der Magnetronquelle 10.

Für die Herstellung eines Schichtsystems Zr / ZrN / ZrO₂ wurden die aus der nachstehenden Tabelle ersichtlichen Prozeßschritte und Prozeßparameter verwendet:

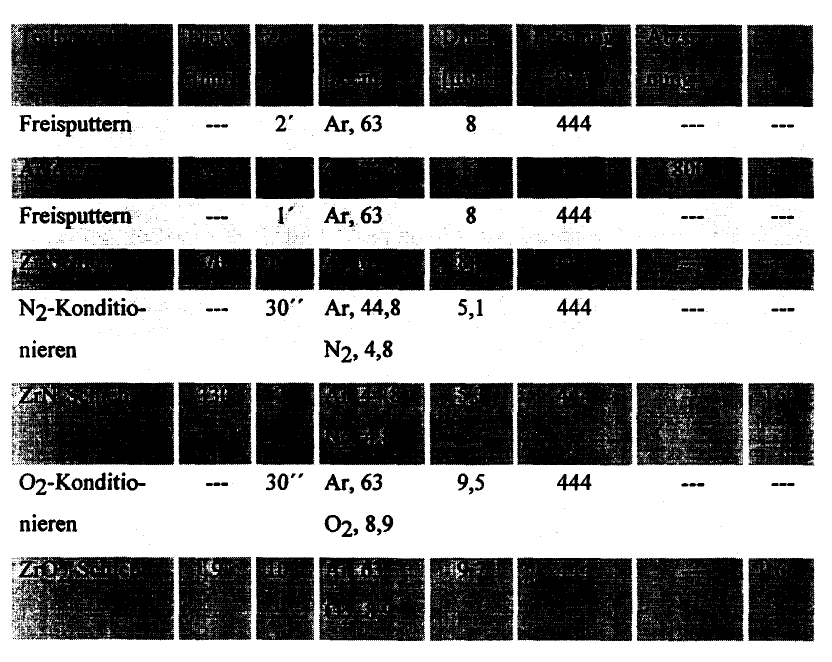

Durch Variation der Oxid-Schichtdicke und der Konzentration des Stickstoff-Anteils im Prozeßgas ließ sich die Farbe des dekorativen Schichtsystems verändern, so daß eine Farbanpassung in bestimmten Grenzen möglich ist.

Die optischen Eigenschaften eines mit den aus der Tabelle ersichtlichen Prozeßparametern erzeugten Schichtsystems sind:
*L**>85; *a**<2,5; *b**=25...29
(Heißwassertest: T = 80°C; t = 24 h; deionisiertes Wasser (L < 0,5 S/cm, nicht entgast); Proben isoliert gelagert)
Schichtdicke: 0,3 ... 0,6 µm.

Die gemessene Farbbeständigkeit und Farbwerte des Systems sind:
*△E*_{*ab*} <1,0 *a**=-2,5 *b**=29,0 *L**>85

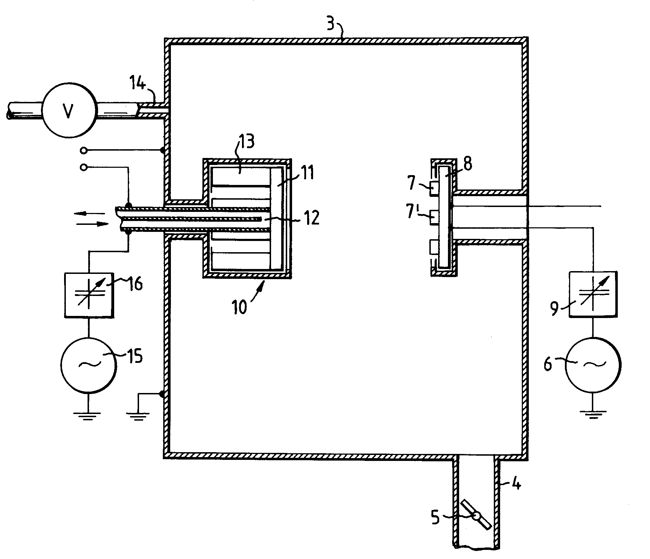

## Patentansprüche

1. Messingfarbige Beschichtung mit einer farbgebenden nitridischen Schicht für Armaturen, Beschläge oder Artikel des täglichen Bedarfs, **dadurch gekennzeichnet,** daß die nitridische Schicht eine Zirkoniumnitridschicht ist und unmittelbar auf das Substrat oder auf eine das Substrat überziehende Grundschicht, beispielsweise eine Zirkoniumschicht als Zwischenschicht aufgebracht ist, wobei auf die Zwischenschicht zum Zwecke des Korrosionsschutzes als Deckschicht eine transparente oxidische Hartstoffschicht, vorzugsweise eine Zirkoniumoxidschicht niedergeschlagen ist.

2. Verfahren zur Herstellung einer Beschichtung nach Anspruch 1, **dadurch gekennzeichnet,** daß das Aufbringen der Zwischenschicht durch Aufstäuben erfolgt, wozu dem Substrat benachbart in der Prozeßkammer eine Magnetronquelle mit einem Zirkonium-Target angeordnet ist und als Prozeßgas ein Gemisch aus Argon und Stickstoff dient, wobei das Aufbringen der Deckschicht durch Aufstäuben unter Verwendung eines Zirkonium-Targets in einem Gemisch aus Argon und Sauerstoff als Prozeßgas erfolgt.

3. Verfahren nach Anspruch 2, **dadurch gekannzeichnet,** daß die Zwischenschicht eine Zirkoniumnitridschicht mit einer Dicke von 50 nm bis 800 nm und die Deckschicht eine Zirkoniumoxidschicht mit einer Dicke von 1 nm bis 50 nm ist.
